# EUROPEAN PATENT APPLICATION

(11) **EP 3 190 629 A1**
(43) Date of publication of application: **12.07.2017**
(21) Application number: 15849815.4
(22) Date of filing: 14.05.2015
(51) Int. Cl.: H01L 31/0288, H01L 31/068, H01L 31/0216

(54) **HIGH-EFFICIENCY N-TYPE DOUBLE-SIDED SOLAR CELL**

(30) Priority: 19.11.2014 CN 201420697301 U
(71) Applicant: Shanghai Shenzhou New Energy Development Co. Ltd., Shanghai 201112 (CN)
(72) Inventor: ZHENG, Fei, Shanghai 201112 (CN); ZHANG, Zhongwei, Shanghai 201112 (CN); SHI, Lei, Shanghai 201112 (CN); RUAN, Zhongli, Shanghai 201112 (CN); TAO, Zhihua, Shanghai 201112 (CN); ZHAO, Yuxue, Shanghai 201112 (CN)
(74) Representative: Szabo, Zsolt
(86) International application number: PCT/CN2015/078931
(87) International publication number: WO 2016/078365

(57) **Abstract**

The present invention discloses a high-efficiency N-type bifacial solar cell including: an N-type cell base including a structuralized surface; a P-type doped region formed on a front surface of the N-type cell base; a polished passivation layer formed on a back surface of the N-type cell base by etching; an N⁺ passivation layer formed by doping phosphorus into a top portion of the polished passivation layer adjacent to the N-type cell base; a first silicon dioxide layer formed on the P-type doped region and a second silicon dioxide layer disposed on the N⁺ passivation layer; a first silicon nitride antireflection layer formed on the first silicon dioxide layer and a second silicon nitride antireflection layer formed on the second silicon dioxide layer; and a first metal electrode formed on the front surface of the N-type cell base and a second metal electrode formed on the back surface of the N-type cell base. The present invention uses the polished passivation layer and the N⁺ passivation layer to obtain a higher open-circuit voltage, and the double-side printing permits two sides of the cell to collect solar energy when illuminated by sunlight, increasing the overall power output and improving the conversion efficiency of the cell.

## Description

### FIELD OF THE INVENTION

The present invention relates to the field of solar cell manufacturing technology and, more particularly, to a high-efficiency N-type bifacial solar cell.

### DESCRIPTION OF THE PRIOR ART

Most of crystalline silicon solar cells on the market use P-type silicon wafers, i.e., silicon wafers doped with boron. Nevertheless, N-type cells produced from N-type silicon wafers have received more attention in recent years and have been used to make N-type solar cells. N-type silicon wafers are silicon wafers doped with phosphorus. Since N-type silicon wafers have longer minority carriers life time, the resultant cells have higher optical-electrical conversion efficiency. Furthermore, N-type cells have a higher tolerance to metal pollution and have better durability and stability. N-type silicon wafers doped with phosphorus have no boron-oxygen pairs, and the cells have no photoluminescence degradation caused by the boron-oxygen pairs. Due to these advantages of N-type crystalline silicon, N-type silicon wafers are very suitable to produce high-efficiency solar cells. However, it is not easy to achieve large-scale production of N-type high-efficiency cells.

The technical procedures for obtaining high-efficiency N-type solar cells are much complicated than those for P-type solar cells and are subject to severe technical requirements. For example, Panasonic Corporation of Japan (formally Sanyo Corporation which had been acquired by Panasonic Corporation) and SunPower Corporation of U.S. have used N-type materials to produce high-efficiency solar cells and modules thereof. SunPower Corporation of U.S. are manufacturing interdigitated back-contact (IBC) cells, and Panasonic Corporation of Japan are manufacturing HIT (heterojunction with intrinsic thin layer) cells. In addition to complicated processing, the above two cells require high-quality silicon materials and surface passivation. Furthermore, IBC cells require high alignment accuracy of metal contacts on the back surface. Although N-type monocrystalline silicon wafers are available in this country and include features of simple structure, bifacial electricity generating ability, and high optical-electrical conversion efficiency, the surface passivation performance of silicon wafers must be increased by selective emitter technology to obtain a better back surface field passivation effect, the basic principle and structure of which are the same as the elective emitter and are widely used in corrosive slurry technology to prepare a selective back surface field. Alternatively, a boron-based paste is printed on the front surface to obtain a selective emitter to thereby obtain a better fill factor for obtaining higher conversion efficiency. No matter the front surface or the back surface, printing alignment problem exists in manufacture of bifacial cells and has a higher demand in production and the technicians. Furthermore, the procedure of cleaning corrosive paste consumes a large amount of water and generates a large amount of toxic pollutants.

China Patent No. CN203103335U discloses a bifacial solar cells using a P-type silicon wafer as the silicon substrate for serving as the base of the solar cell. An emitter, a front passivation/antireflection layer, and a front electrode are disposed on the front surface of the silicon substrate in sequence. A boron back surface field, a rear passivation/antireflection layer, and a back electrode are disposed on the back surface of the silicon substrate. This patent is a P-type doped cell having a differing type of doping in comparison with an N-type doped cell, such that the technologies and ingredients used on the emitter and the front electrode on the front surface and the back surface field, the rear passivation, and the back electrode are completely different, and the resultant cells have different conversion efficiencies.

### BRIEF SUMMARY OF THE INVENTION

An objective of the present invention is to overcome the disadvantages of the prior art by providing a high-efficiency N-type bifacial solar cell capable of assuring a better open-circuit voltage of the cell.

The objective of the present invention is fulfilled by the following technical solutions. The present invention provides a high-efficiency N-type bifacial solar cell including:
an N-type cell base including a structuralized surface;
a P-type doped region formed on a front surface of the N-type cell base;
a polished passivation layer formed on a back surface of the N-type cell base by etching;
an N⁺ passivation layer formed by doping phosphorus into a top portion of the polished passivation layer adjacent to the N-type cell base;
a first silicon dioxide layer formed on the P-type doped region and a second silicon dioxide layer disposed on the N⁺ passivation layer;
a first silicon nitride antireflection layer formed on the first silicon dioxide layer and a second silicon nitride antireflection layer formed on the second silicon dioxide layer; and
a first metal electrode formed on the front surface of the N-type cell base and a second metal electrode formed on the back surface of the N-type cell base.

In the high-efficiency N-type bifacial solar cell according to the present invention, after printing the metal electrodes, the carriers generated by the light incident to the back side of the solar cell are collected under the action of the phosphorus back surface field, achieving a bifacial optical-electrical conversion effect to significantly increase the power output while breaking the optical-electrical conversion efficiency limitation of cells resulting from single-side light reception of single-sided cells. Furthermore, the heavy phosphorus doping in the back side of the solar cell avoids warping of the cell while permitting processing of a thinner silicon substrate. Furthermore, the polished passivation layer and the N⁺ passivation layer can increase the open-circuit voltage of the cell to further improve the conversion efficiency of the cell. In comparison with currently available P-type bifacial cells, the present invention possesses a better weak light response and high-temperature characteristics and generate more power in the morning and evening.

Further improvement of the high-efficiency N-type bifacial solar cell according to the present invention is that the N-type cell base is an N-type silicon wafer doped with phosphorus. The N-type cell base using an N-type silicon wafer has longer minority carriers life time in comparison with P-type solar cells of the current technology.

Further improvement of the high-efficiency N-type bifacial solar cell according to the present invention is that the P-type doped region has a square resistance of 30Ω/□-130Ω/□.

Further improvement of the high-efficiency N-type bifacial solar cell according to the present invention is that polished passivation layer has reflectivity larger than 15%.

Further improvement of the high-efficiency N-type bifacial solar cell according to the present invention is that the N⁺ passivation layer has a square resistance of 20Ω/□-90Ω/□ and a thickness of 0.3µm-0.8µm.

Further improvement of the high-efficiency N-type bifacial solar cell according to the present invention is that the first silicon nitride antireflection layer has a thickness of 50nm-100nm and has a refractive index of 2.0-2.3.

Further improvement of the high-efficiency N-type bifacial solar cell according to the present invention is that the second silicon nitride antireflection layer has a thickness of 50nm-110nm and has a refractive index of 1.9-2.2.

Further improvement of the high-efficiency N-type bifacial solar cell according to the present invention is that each of the first metal electrode and the second metal electrode is comprised of busbar and finer electrodes, wherein the number of the busbar electrodes is 0-5, and the number of the finger electrodes is 70-100.

### DESCRIPTION OF THE DRAWINGS

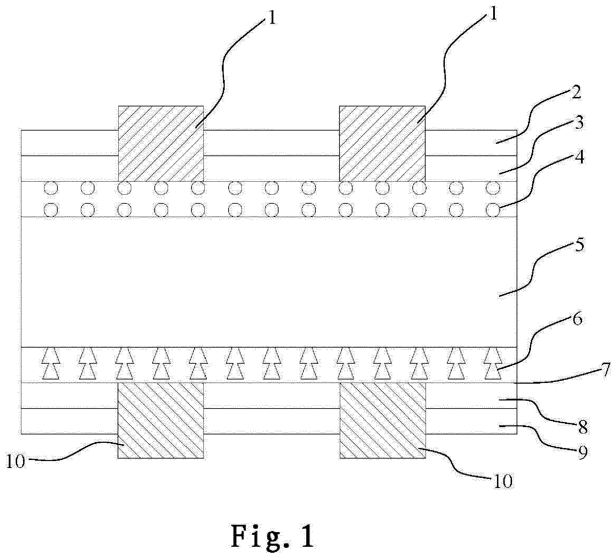

FIG. 1 is a diagrammatic structural view of a high-efficiency N-type bifacial solar cell according to the present invention.

In this figure, 1 is first metal electrode, 2 is first silicon nitride antireflection layer, 3 is first silicon dioxide layer, 4 is P-type doped region, 5 is N-type cell base, 6 is N⁺ passivation layer, 7 is polished passivation layer, 8 is second silicon dioxide layer, 9 is second silicon nitride antireflection layer, and 10 is second metal electrode.

### DETAILED DESCRIPTION OF THE INVENTION

To more clearly understand the objectives, technical solutions, and advantages of the present invention, the present invention will be further described in connection with the accompanying drawings and embodiments. It is noted that the embodiments described herein are merely used to explain the present invention and should not be used to restrict the present invention.

Please refer to FIG. 1. FIG. 1 is a diagrammatic structural view of a high-efficiency N-type bifacial solar cell according to the present invention. As shown in FIG. 1, the high-efficiency N-type bifacial solar cell according to the present invention includes:
an N-type cell base 5 including a structuralized surface;
a P-type doped region 4 formed on a front surface of the N-type cell base;
a polished passivation layer 7 formed on a back surface of the N-type cell base 5 by etching;
an N⁺ passivation layer 6 formed by doping phosphorus into a top portion of the polished passivation layer 7 adjacent to the N-type cell base 5;
a first silicon dioxide layer 3 formed on the P-type doped region 4 and a second silicon dioxide layer 8 disposed on the N⁺ passivation layer 6;
a first silicon nitride antireflection layer 2 formed on the first silicon dioxide layer 3 and a second silicon nitride antireflection layer 9 formed on the second silicon dioxide layer 8; and
a first metal electrode 1 formed on the front surface of the N-type cell base 5 and a second metal electrode 10 formed on the back surface of the N-type cell base 5.

Specifically, the N-type cell base 5 includes a structuralized surface by elective corrosion. Preferably, the N-type cell base 5 uses an N-type silicon wafer doped with phosphorus, which has longer minority carrier life time in comparison with P-type solar cells of the current technology.

The P-type doped region 4 is formed on the front surface of the N-type cell base 5 by heat diffusion or ion implantation and has a square resistance of 30Ω/□-130Ω/□.

The polished passivation layer 7 is formed on the back surface of the N-type cell base 5 by wet etching. An ion implantation technique (such as phosphorus doping technique) is applied to the top portion of the polished passivation layer 7 adjacent to the N-type cell base 5 to form the N⁺ passivation layer 6. The polished passivation layer 7 and the N⁺ passivation layer 6 form an N-type heavily doped region. Preferably, the reflectivity of the polished passivation layer 7 is larger than 15%. The N⁺ passivation layer 6 has a square resistance of 20Ω/□-90Ω/□. The N⁺ passivation layer 6 has a thickness of 0.3µm-0.8µm.

The first silicon dioxide layer 3 and the second silicon dioxide layer 8 are respectively formed on the P-type doped region 4 and the N⁺ passivation layer 6 after heating and oxidation. The main component of the first silicon dioxide layer 3 and the second silicon dioxide layer 8 is silicon dioxide. The first silicon nitride antireflection layer 2 and the second silicon nitride antireflection layer 9 are respectively deposited on the first silicon dioxide layer 3 and the second silicon dioxide layer 8. Preferably, the first silicon nitride antireflection layer 2 has a thickness of 50nm-100nm and has a refractive index of 2.0-2.3, and the second silicon nitride antireflection layer 9 has a thickness of 50nm-110nm and has a refractive index of 1.9-2.2.

The first metal electrode 1 and the second metal electrode 10 are respectively printed on the front surface and the rear surface of the N-type cell base 5. Each of the first metal electrode 1 and the second metal electrode 10 is comprised of busbar and finger electrodes. The number of the busbar electrodes is 0-5, and the number of the finger electrodes is 70-100. In the embodiment shown, the number of the busbar electrodes of the first metal electrode 1 is 2, and the number of the busbar electrodes of the second metal electrode 10 is also 2.

In the high-efficiency N-type bifacial solar cell according to the present invention, after printing the metal electrodes 1 and 10, the carriers generated by the light incident to the back side of the solar cell are collected under the action of the phosphorus back surface field, achieving a bifacial optical-electrical conversion effect to significantly increase the power output while breaking the optical-electrical conversion efficiency limitation of cells resulting from single-side light reception of single-sided cells. Furthermore, the heavy phosphorus doping in the back side of the solar cell avoids warping of the cell while permitting processing of a thinner silicon substrate. Furthermore, the polished passivation layer 7 and the N⁺ passivation layer 6 can increase the open-circuit voltage of the cell to further improve the conversion efficiency of the cell. In comparison with currently available P-type bifacial cells, the present invention possesses a better weak light response and high-temperature characteristics and generate more power in the morning and evening.

The foregoing describes the preferred embodiments of the invention and is not intended to restrict the invention in any way. Although the invention has been described in connection with the above embodiments, however, the embodiments are not used to restrict the invention. A person skilled in the art can make equivalent embodiments with equivalent changes through some alterations or modifications to the invention based on the above disclosed technical contents without departing from the scope of the technical solutions of the invention. Nevertheless, any contents not beyond the technical solutions of the invention and any simple alterations, equivalent changes and modifications to the above embodiments based on the technical substantiality of the invention are still within the scope of the technical solutions of the invention.

## Claims

1. A high-efficiency N-type bifacial solar cell comprising:
an N-type cell base including a structuralized surface;
a P-type doped region formed on a front surface of the N-type cell base;
a polished passivation layer formed on a back surface of the N-type cell base by etching;
an N⁺ passivation layer formed by doping phosphorus into a top portion of the polished passivation layer adjacent to the N-type cell base;
a first silicon dioxide layer formed on the P-type doped region and a second silicon dioxide layer disposed on the N⁺ passivation layer;
a first silicon nitride antireflection layer formed on the first silicon dioxide layer and a second silicon nitride antireflection layer formed on the second silicon dioxide layer; and
a first metal electrode formed on the front surface of the N-type cell base and a second metal electrode formed on the back surface of the N-type cell base.

2. The high-efficiency N-type bifacial solar cell as claimed in claim 1, wherein the N-type cell base is an N-type silicon wafer doped with phosphorus.

3. The high-efficiency N-type bifacial solar cell as claimed in claim 1, wherein the P-type doped region has a square resistance of 30Ω/□-130Ω/□.

4. The high-efficiency N-type bifacial solar cell as claimed in claim 1, wherein the polished passivation layer has reflectivity larger than 15%.

5. The high-efficiency N-type bifacial solar cell as claimed in claim 1, wherein the N⁺ passivation layer has a square resistance of 20Ω/□-90Ω/□ and a thickness of 0.3µm-0.8µm.

6. The high-efficiency N-type bifacial solar cell as claimed in claim 1, wherein the first silicon nitride antireflection layer has a thickness of 50nm-100nm and has a refractive index of 2.0-2.3.

7. The high-efficiency N-type bifacial solar cell as claimed in claim 1, wherein the second silicon nitride antireflection layer has a thickness of 50nm-110nm and has a refractive index of 1.9-2.2 .

8. The high-efficiency N-type bifacial solar cell as claimed in claim 1, wherein each of the first metal electrode and the second metal electrode is comprised of busbar and finger electrodes, a number of the busbar electrodes is 0-5, and a number of the finger electrodes is 70-100.
